# EUROPEAN PATENT APPLICATION

(11) **EP 0 926 732 A2**
(43) Date of publication of application: **30.06.1999**
(21) Application number: 98123429.7
(22) Date of filing: 09.12.1998
(51) Int. Cl.: H01L 23/31, H01L 23/29

(54) **Process for producing semiconductor device and pressure-sensitive adhesive sheet for surface protection**

(30) Priority: 10.12.1997 JP 34001897
(71) Applicant: NITTO DENKO CORPORATION, Osaka (JP)
(72) Inventor: Namikawa, Makoto c/o NITTO DENKO CORPORATION, Ibaraki-shi, Osaka (JP); Okawa, Yuji c/o NITTO DENKO CORPORATION, Ibaraki-shi, Osaka (JP); Nukaga, Jiro c/o NITTO DENKO CORPORATION, Ibaraki-shi, Osaka (JP); Akada, Yuzo c/o NITTO DENKO CORPORATION, Ibaraki-shi, Osaka (JP)
(74) Representative: Grünecker, Kinkeldey, Stockmair & Schwanhäusser Anwaltssozietät

(57) **Abstract**

Described is a process for producing a semiconductor device which comprises, upon production of said semiconductor device, adhering a surface protecting pressure-sensitive adhesive sheet on the main surface side of a semiconductor wafer having a circuit formed thereon and a resist material on the circuit, grinding the reverse side of said wafer while protecting said main surface side and then peeling said pressure-sensitive adhesive sheet to remove said resist material, which has been transferred by adhesion to said pressure-sensitive adhesive sheet, from said wafer. This process makes it possible to improve the workability upon production, reduce the number of the steps, thereby suppressing a percent defective and avoid various harms which would otherwise occur owing to water infiltrated upon reverse-side grinding.

## Description

### FIELD OF THE INVENTION

The present invention relates to a process for producing a semiconductor device and also a pressure-sensitive adhesive sheet, tape or the like for protecting the surface of the device (hereinafter referred to as "surface-protecting pressure-sensitive adhesive sheet", inclusively).

### BACKGROUND OF THE INVENTION

In a semiconductor device, with a view to protecting the surface of the wafer, a passivation film is formed all over the wafer after the formation of a circuit device or interconnects thereon. For electrical connection with external wiring, a through-hole is formed by patterning a resist on the passivation layer and then etching the passivation layer with this resist as a mask. The resist material which becomes unnecessary is usually removed by a solvent or asher. Then, in order to make the wafer thinner, the wafer is ground at its reverse side, while the main surface side of the wafer is protected by a surface-protecting pressure-sensitive adhesive tape adhered thereto.

In some cases, a surface protecting film such as polyimide film having a thickness of about 1 to 15 µm is laid over the above-described passivation film. In recent days, the inspection of circuits tends to be carried out not after but before the grinding step of the reverse side of the wafer. Upon the inspection, an inferior product is distinguished by making a mark on the inferior chip with an ink so that the wafer is inevitably provided for the subsequent grinding step with an ink dot of about 10 to 40 µm in height disposed on the surface of the wafer. In addition to the above tendency, a bump of about 20 to 100 µm in height tends to be disposed on the surface of the wafer owing to an increase in the package forms such as chip size package and in this case, the wafer is provided for the subsequent grinding step with the bump thereon.

The conventional process for the production of a semiconductor device is therefore accompanied with the problems that because of the necessity of cumbersome steps for removing the resist material, which becomes unnecessary after etching of the passivation film, by a solvent or ashing and then, while protecting the main surface side of the wafer with a surface-protecting pressure-sensitive adhesive tape adhered thereon, grinding the reverse side of the wafer, much time and labor are required and the percent defective increases in proportion to the number of the steps. In addition, the adhesion of the surface-protecting pressure-sensitive adhesive tape does not completely protect the surface of the wafer and water infiltrated into the main surface side of the wafer upon grinding of the reverse side happens to bring about various harms.

The harms attributable to the infiltration of water are observed eminently in the case where a surface protecting film such as polyimide film is laid over the passivation film or the ink dot or bump as described above is disposed on the passivation film and they cause serious problems. Described specifically, a step difference on the wafer surface between a portion of a scribe line to be disposed for dicing and the other portion becomes large and a space appears at the scribe line portion when a surface-protecting pressure-adhesive adhesive tape is adhered onto the wafer surface. Upon grinding of the reverse side, water for cooling or washing infiltrates into this space and contaminates the scribe line portion or in an extreme case, water infiltrates even onto the circuit and causes harms such as cracking of the wafer or contamination of an aluminum pad portion.

### SUMMARY OF THE INVENTION

An object of the present invention is therefore to provide a process for the production of a semiconductor device, which is improved in the workability upon production, is reduced in the number of steps to suppress a percent defective and is free from various harms resulting from the infiltration of water upon reverse-side grinding.

With a view to attaining the above-described object, the present inventors have carried out an extensive investigation. As a result, it has been found that when the removal of the resist material which becomes unnecessary after the etching of the passivation film is carried out not by a solvent or ashing but by adhering a surface-protecting pressure-sensitive adhesive sheet to the main surface side of the wafer to protect it, and after grinding the reverse side of the wafer while protecting the surface with the sheet, peeling the sheet together with the resist material transferred thereto by adhesion, the removal of the resist material and grinding of the reverse side of the wafer can be carried out by only one step. This facilitates the production work, the reduction in the number of the steps makes it possible to suppress a percent defective, and even if a surface protecting film such as polyimide film is laid or an ink dot or bump is disposed on the passivation film, the main surface side of the wafer is protected favorably without harms such as contamination of the scribe line portion, cracking of wafer or contamination of the aluminum pad portion.

The present invention provides a process for the production of a semiconductor device which comprises, upon production of the semiconductor device, adhering a surface-protecting pressure-sensitive adhesive sheet to a main surface side of a semiconductor wafer having a circuit formed thereon and a resist material on the circuit, grinding the reverse side of the wafer while protecting the main surface side, and peeling the pressure-sensitive adhesive sheet to remove the resist material adhered to the pressure-sensitive adhesive sheet from the wafer. It is preferred that the surface-protecting pressure-sensitive adhesive sheet comprises a curable pressure-sensitive adhesive layer and the pressure-sensitive adhesive sheet is cured after the grinding of the reverse side of the wafer but before the peeling of the pressure-sensitive adhesive sheet.

Furthermore, the present invention provides a surface protecting pressure-sensitive adhesive sheet which has a curable pressure-sensitive adhesive layer and is employed for the above-described production process of a semiconductor device, which comprises a film base permeable to ultraviolet ray and a ultraviolet-curable pressuresensitive adhesive layer formed thereon, wherein the ultraviolet-curable pressure-sensitive adhesive layer has an initial modulus which increases by at least 5 times after curing and is one obtained by incorporating 20 to 200 parts by weight of a nonvolatile low-molecular weight substance containing at least one polymerizable carbon to carbon double bond and 0.1 to 10 parts by weight of a photopolymerization initiator in 100 parts by weight of an alkyl (meth)acrylate polymer having a weight-average molecular weight of 300,000 to 2,000,000. The ultraviolet-curable pressure-sensitive adhesive layer preferably has a thickness of at least 20 µm.

### DETAILED DESCRIPTION OF THE INVENTION

The surface-protecting pressure-sensitive adhesive sheet to be used in the present invention is obtained by providing a pressure-sensitive adhesive layer on a base film and forming the resulting film into a tape, sheet or the like. As the base film, a plastic film, such as polyester film, having a thickness of 10 to 1,000 µm is generally used. Furthermore, a non-woven fabric, woven fabric or net (for example, a net not greater than 400 mesh/inch for screen printing) made of synthetic fibers such as nylon or polyester can be used.

As a material rich in expansion, the plastic film is preferred to have a tensile modulus not greater than 50 kg/mm² (usually not less than 0.1 Kg/mm²) as measured in accordance with JIS-K-7127. Examples of the plastic film include, in addition to the polyester film, polyethylene film, ethylene-propylene copolymer film, ethylene-ethyl (meth)acrylate copolymer film and ethylene-vinyl acetate copolymer film. In order to improve the anchoring property with the pressure-sensitive adhesive layer, the film may be subjected to surface treatment such as corona treatment on the surface to have the pressure-sensitive adhesive layer formed thereon.

The pressure-sensitive adhesive layer to be disposed on such a film base generally has a thickness of at least 20 µm, preferably at least 30 µm (usually, not greater than 100 µm). The adhesive layer may be either a non-curable type or a curable type. In the present invention, a curable type pressure-sensitive adhesive layer, particularly, ultraviolet-curable type pressure-sensitive adhesive layer is preferred for protecting the surface of the circuit-formed wafer and completely removing the resist material from the surface of the wafer by peeling.

Examples of the surface-protecting pressure-sensitive adhesive sheet having a ultraviolet-curable type pressure-sensitive adhesive layer include a surface-protecting pressure-sensitive adhesive sheet having, on a film base permeable to ultraviolet ray, a ultraviolet-curable pressure-sensitive adhesive layer having a thickness of at least 20 µm and an initial modulus which increases by at least 5 times by curing to thereby lower the adhesion, which is one obtained by incorporating 20 to 200 parts by weight of a nonvolatile low-molecular weight substance containing at least one polymerizable carbon to carbon double bond (hereinafter referred to as "curable compound"), 0.1 to 10 parts by weight of a photopolymerization initiator, and optionally, an isocyanate crosslinking agent and the other additives, into 100 parts by weight of an alkyl (meth)acrylate polymer having a weight-average molecular weight of 300,000 to 2,000,000. The total amount of the isocyanate crosslinking agent and other additives is generally 100 parts by weight or less, preferably 20 parts by weight or less based on 100 parts by weight of the polymer.

Examples of the alkyl (meth)acrylate polymer include homopolymers of alkyl (meth)acrylates and copolymers of an alkyl (meth)acrylate and a carboxyl- or hydroxyl-containing monomer or the other monomers for modification. Examples of the monomers which can be used for preparing the alkyl (meth) acrylate polymer include butylacrylate(BA), ethylacrylate (EA), 2-ethylhexylacrylate (2-EHA), methylacrylate (MA), methylmethacrylate (MMA), acrylonitrile (AN), acrylic acid (AA), and hydroxyethylacrylate (HEA), and vinylacetate (VAc). The preparation can be effected according to known methods such as solution polymerization, emulsion polymerization and bulk polymerization.

Examples of the curable compound include polyethylene glycol di(meth)acrylate, dipentaerythritol hexa(meth)acrylate, trimethylolpropane tri(meth)acrylate, tetramethylolmethane tri(meth)acrylate, oligoester (meth)acrylate and urethane (meth)acrylate oligomer. Examples of the photopolymerization initiator include benzoin, benzoin ethyl ether, dibenzyl, benzophenone, dodecyl thioxanthone, benzyldimethyl ketal and [dimethoxy(phenyl)]methyl phenyl ketone.

In the present invention, a semiconductor device is fabricated as described below by using such a surface-protecting pressure-sensitive adhesive sheet. First, the surface-protecting pressure-sensitive adhesive sheet is adhered to the main surface side of a semiconductor wafer having a circuit thereon and a resist material over the circuit. At this time, the sheet is rendered to have affinity with the resist material by pressure and/or heating and they are then stuck sufficiently each other, whereby the surface of the wafer is protected uniformly. The wafer may have, on the circuit-formed surface thereof, irregularities having a height of from 3 to 200 µm, preferably from 3 to 150 µm, at the maximum, which have been formed by the previous steps, or a passivation film which has been etched through the resist material thereon. Over the passivation film, a surface-protecting film such as polyimide film may be formed. The height of the irregularities is one calculated taking a lower one of the scribe line and the electrode pad portion as the starting point. On the circuit-formed surface of the wafer, an ink dot may be put to discriminate the inferior chips after the inspection of the circuit or a bump may be disposed. The height of the irregularities is one from the surface of a lower one of the scribe line and electrode pad portion.

The semiconductor wafer is then adjusted to a desired thickness by grinding the reverse side of the wafer while protecting the main surface side of the wafer. The grinding is carried out in a conventional manner. At this time, water for cooling and washing is injected at high pressure. Since the sheet integral with the resist material is closely adhered to the surface of the wafer, infiltration of water to the surface of the wafer can be prevented. There is therefore no problem of the contamination of the scribe line portion and also harms, which would otherwise occur by the infiltration of water even onto the circuit, such as cracking of wafer or contamination of the aluminum pad portion.

After grinding of the reverse side of the wafer, the pressure-sensitive adhesive sheet, when it is a curable type, is cured by exposure to ultraviolet rays to lower its adhesion, and then peeled to remove the resist material adhered and transferred to the pressure-sensitive adhesive sheet from the wafer. According to the above-described constitution, the removal of the resist material from the surface of the wafer and grinding of the reverse side of the wafer can be accomplished at the same time, which makes it possible to improve the workability upon production of a semiconductor device and to reduce the number of the steps, thereby decreasing a percent defective, compared with the conventional production process. In addition, prevention of harms caused by the infiltrated water as described above upon grinding of the reverse side of wafer also contributes to a reduction in the percent defective, resulting in a drastic improvement in the yield of end products.

In the present invention, as described above, the surface-protecting pressure-sensitive adhesive sheet is adhered to the resist material remaining on the surface of the wafer after etching of the passivation film and the resist material and the pressure-sensitive adhesive sheet can be peeled integrally after grinding of the reverse side of the wafer. It is however to be noted that various modifications within an extent not departing from the technical concept of the present invention are feasible. For example, it is possible to subject, after removal of a first resist material, a second resist material which has been applied for its peculiar purpose and subjected to necessary steps such as etching to adhesion of a surface-protecting pressure-sensitive adhesive sheet, grinding of the reverse side of the wafer and integral peeling of the resist material with the sheet.

### EXAMPLES

The present invention will be described more specifically by examples below. All the "part" or "parts" are by weight.

### EXAMPLE 1

A monomer mixture composed of 80 parts of n-butyl acrylate, 15 parts of ethyl acrylate and 5 parts of acrylic acid was subjected to solution polymerization at 60°C for 12 hours under a nitrogen stream by the use of 150 parts of ethyl acetate and 0.1 part of azobisisobutyronitrile. Thus, Polymer solution A containing a copolymer having a weight-average molecular weight of 500,000 was obtained.

Ten parts of polyethylene glycol diacrylate, 10 parts of dipentaerythritol hexaacrylate, and 30 parts of trimethylolpropane triacrylate (based on 100 parts of the copolymer) were added to Polymer Solution A, followed by uniform mixing with 3 parts of diphenylmethane diisocyanate and 3 parts of [dimethoxy(phenyl)]methyl phenyl ketone. Thus, an ultraviolet-curable type pressure-sensitive adhesive solution was prepared.

The resulting pressure-sensitive adhesive solution was applied to a polyester film having a thickness of 50 µm to give a dry thickness of 35 µm, followed by drying at 130°C for 3 minutes. Thus, an ultraviolet-curable type surface-protecting pressure-sensitive adhesive sheet was prepared. The 180° peel strength of the resulting pressure-sensitive adhesive sheet from the silicon wafer was 250 g/10 mm width before exposure to ultraviolet rays, while it was 13 g/10 mm width after exposure to ultraviolet rays.

To an 8-inch silicon wafer (thickness: 730 µm) having a desired circuit on its surface, a passivation film formed all over the circuit and over the passivation film, a negative resist material having a thickness of 5 µm which would remain after the etching of the passivation film, the above ultraviolet-curable type surface-protecting pressure-sensitive adhesive sheet was contact-bonded on a plate heated to 90°C. Under that condition, the reverse side of the wafer was ground by a grinder ("DFG840", manufactured by DISCO CO.) to a finish roughness of #2000 and final thickness of 280 µm.

After grinding, the surface-protecting pressuresensitive adhesive sheet was cured by exposure to ultraviolet rays of 900 mj/cm² under a high-pressure mercury lamp. After curing, the pressure-sensitive adhesive sheet was peeled, by which the resist material was removed together with the pressure-sensitive adhesive sheet. Thus, the removal of the resist material and grinding of the reverse side of the wafer can be carried out by one step, which makes it possible to improve the workability upon production, reduce a percent defective and prevent the harms caused by the infiltration of water into the wafer surface upon grinding, resulting in a drastic improvement in the yield of the end product.

In Example 1, it has been confirmed that even if a surface-protecting film such as polyimide film was formed on the passivation film over the circuit-formed surface of the wafer or an ink dot or bump was disposed on the surface of the wafer, infiltration of water did not occur upon the grinding of the reverse side of the wafer and therefore harms such as contamination of the scribe line portion, cracking of wafer or contamination of the aluminum pad portion were avoided.

### EXAMPLE 2

An ultraviolet-curable type pressure-sensitive adhesive solution was prepared in the same manner as in Example 1 except that 20 parts of polyethylene glycol dimethacrylate and 30 parts of dipentaerythritol hexaacrylate, based on 100 parts of the copolymer, were added to Polymer solution A, followed by uniform mixing with the same isocyanate crosslinking agent and photopolymerization initiator as used in Example 1. Using the resulting solution, an ultraviolet-curable type surface-protecting pressure-sensitive adhesive sheet was prepared in the same manner as in Example 1. The 180° peel strength of the resulting pressure-sensitive adhesive sheet from the silicon wafer was 200 g/10 mm width before exposure to ultraviolet rays, while it was 6 g/10 mm width after exposure to ultraviolet rays.

As in Example 1, the resulting ultraviolet-curable type surface-protecting pressure-sensitive adhesive sheet was adhered to an 8-inch silicon wafer having a desired circuit, a passivation film and a negative resist material stacked thereon one after another, followed by grinding of the reverse side of the wafer. The pressure-sensitive adhesive sheet was then peeled after curing. As a result, the resist material was removed together with the pressure-sensitive adhesive sheet by peeling. Similarly to Example 1, it has been confirmed that the production process in this example also makes it possible to improve the workability upon production, reduce the percent defective, prevent harms which would otherwise occur owing to the infiltrated water upon reverse-side grinding, and bring about a drastic improvement in the yield of the end product.

### Measurement of Initial Modulus

The pressure-sensitive adhesive layer obtained in Example 1 had an initial modulus of 0.58 Mpa (0.06 kgf/mm²) before exposure to ultraviolet rays and an initial modulus of 3.5 Mpa (0.36 kgf/mm²) after curing with exposure to ultraviolet rays.

The pressure-sensitive adhesive layer obtained in Example 2 had an initial modulus of 0.85 Mpa (0.087 kgf/mm²) before exposure to ultraviolet rays and an initial modulus of 5.1 Mpa (0.52 kgf/mm²) after curing with exposure to ultraviolet rays.

The initial modulus of the cured pressure-sensitive adhesive layer was obtained as follows. A tape comprising a separator having thereon a pressure-sensitive adhesive layer having a thickness of 50 µm was cut into samples each having a size of 10 × 50 mm. Each sample was irradiated to ultraviolet rays in an accumulated amount of 500 to 1000 mj/cm² under a high-pressure mercury lamp. After removing the separator, the sample was subjected to a tensile test by means of a universal testing machine (at a temperature of 22 to 24°C and a relative humidity of 35 to 50%) pulling the sample in the lengthwise direction with the distance between chucks being 10 mm. The gradient of the obtained chart (strength × the distance between the chucks) is calculated to obtain an initial modulus. The initial modulus of the pressure-sensitive adhesive layer prior to curing was measured in the same manner as above except that the irradiation to ultraviolet rays was not effected.

While the invention has been described in detail and with reference to specific embodiments thereof, it will be apparent to one skilled in the art that various changes and modifications can be made therein without departing from the spirit and scope thereof.

## Claims

1. A process for producing a semiconductor device, which comprises:
adhering a surface-protecting pressure-sensitive adhesive sheet to a main surface side of a semiconductor wafer having a circuit formed thereon and a resist material on the circuit,
grinding the reverse side of said wafer while protecting said main surface side, and
peeling said pressure-sensitive adhesive sheet to remove said resist material adhered to said pressure-sensitive adhesive sheet from said wafer.

2. The process of claim 1, wherein said semiconductor wafer has irregularities of 3 to 200 µm at the maximum on the circuit-formed surface thereof.

3. The process of claim 1, wherein said semiconductor wafer has a passivation film on the circuit-formed surface thereof and optionally a surface protecting film on said passivation film.

4. The process of claim 1, wherein said semiconductor wafer has an ink dot or bump on the circuit-formed surface thereof.

5. The process of claim 1, wherein said surface protecting pressure-sensitive adhesive sheet comprises a curable pressure-sensitive adhesive layer and said process further comprises effecting curing the pressure-sensitive adhesive sheet after grinding the reverse side of said wafer but before peeling said pressure-sensitive adhesive sheet.

6. A surface-protecting pressure-sensitive adhesive sheet which comprises a film base permeable to ultraviolet ray and a ultraviolet-curable pressure-sensitive adhesive layer formed thereon, wherein said ultraviolet-curable pressure-sensitive adhesive layer is one obtained by incorporating 20 to 200 parts by weight of a nonvolatile low-molecular weight substance containing at least one polymerizable carbon to carbon double bond and 0.1 to 10 parts by weight of a photopolymerization initiator in 100 parts by weight of an alkyl (meth)acrylate polymer having a weight-average molecular weight of 300,000 to 2,000,000 and has an initial modulus which increases by at least 5 times after curing.

7. The surface-protecting pressure-sensitive adhesive sheet of claim 6, wherein said ultraviolet-curable pressure-sensitive adhesive layer has a thickness of at least 20 µm.
